Europäisches Patentamt

(19) European Patent Office

Office européen des brevets

(11) Numéro de publication : **0 239 912 B1**

(12) **FASCICULE DE BREVET EUROPEEN**

(45) Date de publication du fascicule du brevet :
30.01.91 Bulletin 91/05

(51) Int. Cl.⁵ : **H05K 7/14, H01P 1/04**

(21) Numéro de dépôt : **87104300.6**

(22) Date de dépôt : **24.03.87**

(54) Dispositif d'accouplement électrique et mécanique d'un coffret hyperfréquences sur à source et sur son support et procédé de mise en oeuvre d'un tel dispositif.

(30) Priorité : **28.03.86 FR 8604515**

(43) Date de publication de la demande :
**07.10.87 Bulletin 87/41**

(45) Mention de la délivrance du brevet :
**30.01.91 Bulletin 91/05**

(84) Etats contractants désignés :
**DE FR GB IT SE**

(56) Documents cités :
**EP-A- 0 128 686**
**DE-B- 1 061 870**
**US-A- 2 928 059**
**US-A- 3 383 633**
**US-A- 4 002 955**

(73) Titulaire : **ALCATEL TRANSMISSION PAR FAISCEAUX HERTZIENS A.T.F.H.**
**55, rue Greffulhe**
**F-92300 Levallois-Perret Cédex (FR)**

(72) Inventeur : **Trift, Olivier**
**59, rue de Bourgogne**
**F-93290 Tremblay les Gonesse (FR)**
Inventeur : **Multon, Alain**
**240 Avenue d'Argenteuil**
**F-92600 Asnieres (FR)**

(74) Mandataire : **Weinmiller, Jürgen et al**
**Lennéstrasse 9 Postfach 24**
**D-8133 Feldafing (DE)**

Jouve, 18, rue Saint-Denis, 75001 PARIS

## Description

L'invention concerne un dispositif d'accouplement électrique et mécanique d'un coffret d'une tête hyperfréquence (HF) avec une enveloppe d'une source hyperfréquence sur un support.

Dans certains dispositifs de l'art connu la fixation mécanique était séparée de la fixation électrique. La fixation mécanique était réalisée à l'aide de plusieurs écrous qui nécessitaient de la part de l'opérateur autant de manipulations que d'écrous.

De même en ce qui concerne la fixation électrique, une vis de centrage nécessitait plusieurs manipulations de la part de l'opérateur.

Pour pallier ces inconvénients, l'invention a pour but de simplifier fortement ces manipulations.

Un document de l'art connu, le brevet américain US-A2.928.059, décrit un dispositif d'accouplement de deux sections de guide d'onde. Ce dispositif comprend, d'une part, une première pièce sur laquelle est montée la première section de guide d'onde ; une bride, percée d'une ouverture et munie de deux pions de centrage, étant située à l'extrémité de cette première section ; un amortisseur étant solidaire de cette bride. Ce dispositif comprend, d'autre part, une seconde pièce sur laquelle est montée la seconde section de guide d'onde ; une bride d'assemblage, percée d'une ouverture et munie de deux orifices destinés à coopérer avec les pions de centrage, étant disposée à l'extrémité de cette seconde section.

L'invention permet d'établir une liaison électrique en hyperfréquences d'une tête hyperfréquence avec sa source, et d'exécuter une liaison mécanique triaxiale de cette tête hyperfréquence sur son support.

Ces buts sont atteints par le dispositif tel que défini par la revendication 1.

Les caractéristiques et avantages de l'invention ressortiront d'ailleurs de la description qui va suivre, à titre d'exemple non limitatif, en référence aux dessins annexés sur lesquels :
– la figure 1 représente le dispositif de l'invention à l'état de repos, le verrouillage étant accompli ;
– les figures 2 à 6 illustrent les différentes étapes de verrouillage du dispositif de l'invention ;
– les figures 7 à 9 illustrent les différentes étapes de déverrouillage du dispositif de l'invention ;
Le dispositif selon l'invention comprend trois parties :
– une base mécanique ou support 10,
– une tête hyperfréquence ou "HF" 11,
– une enveloppe source 12.
La base mécanique 10 supporte :
– un système de charnière mobile 13, lui-même formé de trois éléments : un tirant 14, une partie de fixation 15 et un levier de manoeuvre 16, ce système étant fixé sur le corps de la base mécanique 10 par des vis de fixation 17,
– un ressort de rappel 18 et une vis de réglage 20 de la position de celui-ci,
– une butée arrière 19 en forme de queue d'aronde,
– des pions de positionnement source 32.
La tête hyperfréquence ou "HF" 11 comprend :
– une bride d'assemblage 21 comportant deux orifices 30',
– un crochet 22,
– une butée mobile arrière 23 en forme de queue d'aronde.
L'enveloppe source 12 supporte :
– un guide souple métallique 25 situé dans le prolongement de deux guides rigides 26, 27 dont le second se termine par une collerette 28,
– une bride spécifique 29 fixée à l'extrémité du guide souple 25 et munie de deux pions de centrage 30,
– un amortisseur 31 disposé entre la bride spécifique 29 et le corps de l'enveloppe source 12,
– une butée 37 sur laquelle s'appuie la collerette 28, ce qui permet de maintenir des guides rigides 26 et 27 dans une position fixe.
Les guides rigides 26, 27 et le guide souple 25 sont des guides rectangulaires. Le ressort de rappel 18 a la forme d'une lamelle ayant une extrémité 35 fixée à la base mécanique 10 et l'autre extrémité 36 en forme de "U" évasé.

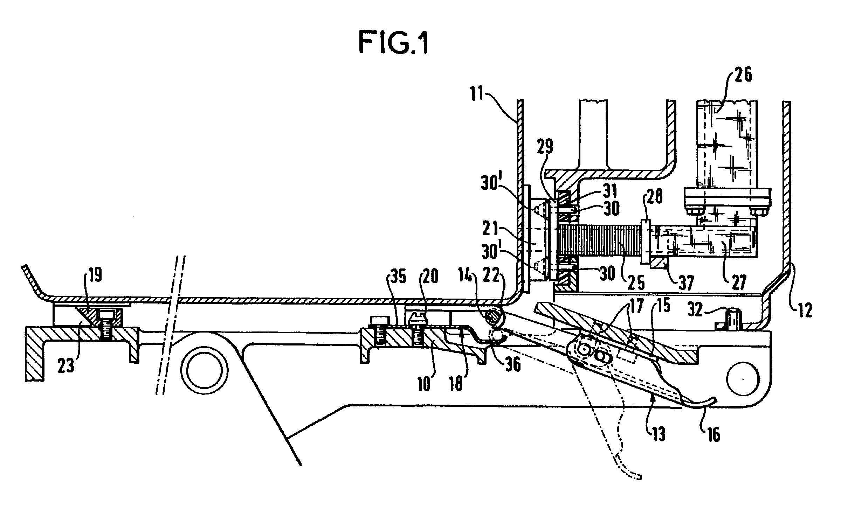

En position de verrouillage des différents éléments : base 10, tête hyperfréquence 11 et enveloppe source 12 représentés en figure 1, la lamelle ressort 18 située sous le coffret de la tête hyperfréquence 11 est parallèle à la partie centrale du crochet 22, et la charnière mobile 13 forme un angle d'environ 30° avec cette direction : cet angle est par exemple compris entre 20° et 45°.

Dans cette position de verrouillage l'enveloppe source 12 et la tête hyperfréquence 11 sont placées du même côté du support 10 et l'une en face de l'autre, de telle sorte que leurs brides respectives 21 et 29, qui sont toutes deux percées d'ouvertures rectangulaires, aient leurs ouvertures en vis à vis, et que les deux pions de centrage 30 soient disposés dans les deux orifices 30' percés dans la bride d'assemblage 21.

L'enveloppe source 12 est maintenue en position grâce aux pions de positionnement 32, et la tête hyperfréquence grâce à la charnière mobile 13.

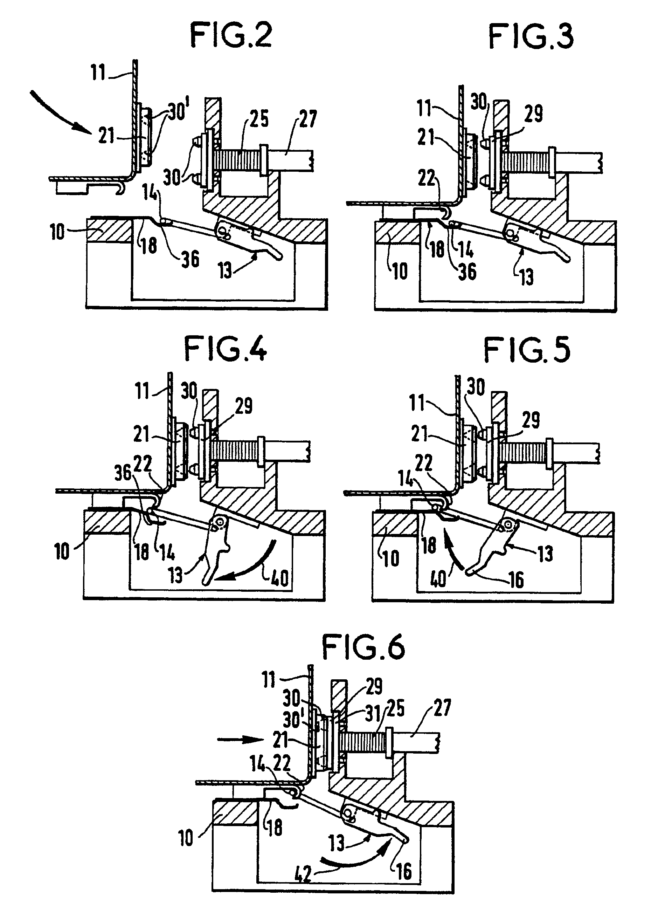

Les différentes phases de verrouillage ou d'accouplement du dispositif de l'invention sont les suivantes :
– Comme représenté la figure 2 l'enveloppe source est d'abord rendue solidaire de la base mécanique 10, le tirant de la charnière mobile repose alors dans le creux 36 en forme de "U" évasé de la lame ressort 18.
– Comme représenté à la figure 3 on pose alors le coffret de la tête hyperfréquence 11 sur la base mécanique 10 de manière à disposer face à face les deux brides 21 et 29, l'extrémité du crochet 22 se trouve alors au dessus de l'extrémité 36 en forme de "U" évasé du ressort de rappel 18.

– Comme représenté à la figure 4, on manoeuvre ensuite le levier 16 de la charnière mobile dans la direction 40, la lame ressort 18 s'efface, permettant de rendre captif du crochet 22 le tirant 14 de la charnière mobile 13, comme représenté à la figure 5.

– Comme représenté à la figure 6, on manoeuvre enfin en sens inverse 42 le levier 16 de la charnière mobile 13. On tire donc le coffret de la tête hyperfréquence 11 pour amener en contact la bride d'assemblage 21 et la bride spécifique 29, les pions de centrage 30 entrant dans les deux orifices correspondants 30'.

Le guide souple 25, et l'amortisseur 31 sont alors comprimés jusqu' ce que la butée arrière mobile 23 vienne se bloquer sur la butée arrière 19.

A la figure 6 les différents éléments sont solidement accouplés aussi bien d'un point de vue mécanique ou électrique grâce notamment au guide souple 25 et à l'amortisseur 31. Le dispositif est alors insensible aux vibrations.

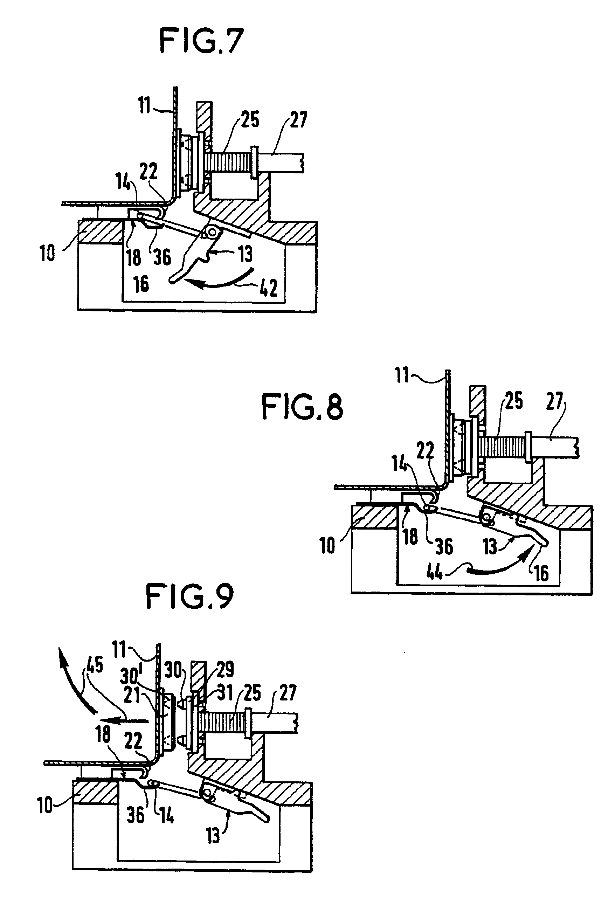

Lors du déverrouillage ou du désaccouplement du dispositif de l'invention, comme représenté à la figure 7, on manoeuvre le levier 16 de la charnière mobile 13 dans la direction 42 jusqu'à ce que le tirant 14 dépasse l'extrémité du crochet 22.

Du fait de la forme de ce crochet 22 et de la forme de l'extrémité 36 de la lamelle ressort 18, quand on ramène le levier 16 en sens inverse, le tirant 14 de la charnière mobile 13 échappe au crochet 22, comme représenté à la figure 8.

Du fait de l'élasticité du guide souple 25 et de l'amortisseur 31 le coffret tête hyperfréquence 11 est repoussé par rapport à l'enveloppe source 12, comme représenté à la figure 9. On peut alors retirer (45) ce coffret tête hyperfréquence 11 de la base mécanique 10.

Le verrouillage et le déverrouillage de la tête hyperfréquence 11 sur l'ensemble base mécanique 10 – enveloppe source 12 est donc réalisé en jouant uniquement sur le levier 16 de la charnière mobile dans un sens puis dans l'autre : l'accouplement se réalise par l'intermédiaire de la charnière mobile 13 et du crochet 22 solidaire du coffret hyperfréquence 11. D'un seul mouvement, la liaison électrique est réalisée par la bride spécifique 29 dont les deux pions 30 permettent le centrage sur la bride d'assemblage 21 fixée sur le coffret hyperfréquence.

La souplesse du contact est obtenue par le guide souple 25 qui permet d'absorber en compression l'effort d'assemblage. La butée 37 limite et maintient la partie rigide du guide. La partie souple de l'ensemble revient à sa position initiale, lors du déverrouillage, aidée en cela par l'amortisseur 31 monté sur l'enveloppe source 12. Cette souplesse, guide-amortisseur, favorise l'absorption dans tous les sens des tolérances dûes aux différentes pièces entrant dans le dispositif.

L'accouplement électrique, précis au niveau de l'interface sortie coffret hyperfréquence 11 et guide d'onde, est assuré par les deux pions 30 de centrage sur la bride 29 côté source. Le contact de masse optimum est rendu possible par l'adaptation géométrique du guide souple 25 et la pression effective de l'accouplement.

La liaison mécanique, blocage du coffret hyperfréquence 11 sur son support 10, s'effectue donc à l'aide de la charnière mobile 13 assurant une traction de l'ordre de 4 à 5 kgf orientée vers le bas.

La butée arrière 23, en forme de queue d'aronde, ainsi que les pions de centrage 30, permettent le positionnement du coffret 11 avec précision vis-à-vis de sa source, supprimant ainsi tous les degrés de liberté.

Le système de charnière mobile 13 a un effet réversible. Lors de son ouverture, son crochet, venant en butée sur le patin avant du coffret et guidé par la lame ressort 18, permet le désaccouplement mécanique et électrique de l'ensemble.

La liaison mécanique du coffret hyperfréquence sur son support fonderie 10 toujours par l'intermédiaire de la charnière mobile est réalisée par l'ensemble de queue d'aronde 23, 19.

Le ressort de rappel 18 assure le retour du tirant de la charnière mobile ou genouillère dans son mouvement. Ce ressort fixé par deux vis dont l'une détermine un degré de liberté supplémentaire du coffret hyperfréquence.

Lors du déverrouillage, le tirant 14 de la charnière mobile permet, par son déplacement guidé, d'échapper tout ce qui est centrage (pièces 30, 20).

Les deux pions 32 ont pour fonction de positionner l'ensemble source sur la fonderie et d'obtenir le centrage source-coffret hyperfréquence.

L'amortisseur 31 est par exemple en mousse cellulaire à cellule ouverte pour permettre de rattraper les jeux mécaniques. Pour qu'il puisse revenir après compression à sa position origine il a une dureté comprise, par exemple, entre 40 et 60 shores.

La lame de ressort 18 qui doit être flexible est par exemple en bronze beryllum.

Ce dispositif de l'invention satisfait les conditions techniques suivantes :

– Taux d'ondes stationnaires TOS = 1,15

– pertes < 0,3 ;

– tenue aux vibrations tant pour la mécanique que le respect de la liaison hyperfréquence ;

– Aucune rupture de contact au niveau des brides d'accouplement n'est enregistrée du fait de la souplesse obtenue grâce au guide et à son amortisseur ;

– Le fonctionnement de la liaison est également fiable dans une gamme de température allant de –40°C à +60°C.

## Revendications

1. Dispositif d'accouplement électrique et mécanique d'un coffret d'une tête hyperfréquence avec une enveloppe (12) d'une source hyperfréquence sur un support (10), le support (10) comprenant sur l'une de ses faces un système de charnière mobile (13), la charnière mobile étant constituée d'un tirant (14), d'une partie de fixation (15) et d'un levier de manoeuvre (16), le support comprenant aussi un ressort de rappel (18) en forme de lamelle fixé sur le support, le ressort étant immobilisé à l'une de ses extrémités et situé de telle manière que le tirant (14) du système de charnière mobile puisse reposer sur l'extrémité libre (36) de ce ressort (18), le support comprenant en outre une butée arrière (19), et des pions (32) de positionnement de l'enveloppe de la source, l'enveloppe de la source (12) comprenant un guide d'onde souple (25) métallique, et, disposée sur l'une de ses faces, une bride spécifique (29) qui est situé à l'extrémité de ce guide d'onde souple et qui est percée d'une ouverture et munie de deux pions de centrage (30) assurant aussi l'accouplement électrique, un amortisseur (31) étant disposé entre cette bride (29) et le corps de l'enveloppe de la source, le coffret de la tête hyperfréquence (11) comprenant sur une première face une bride d'assemblage (21) percée d'une ouverture et munie de deux orifices (30') destinées à coopérer avec les pions de centrage et sur une deuxième face un crochet (22) permettant de rendre captif le tirant et une autre butée arrière (23) qui vient se bloquer sur la butée arrière du support lorsque le coffret est accouplé à l'enveloppe.

2. Dispositif selon la revendication 1, caractérisé en ce que le guide d'onde souple (25) est situé dans le prolongement de guides d'ondes rigides (26, 27).

3. Dispositif selon la revendication 2, caractérisé en ce que ces guides d'ondes (25, 26, 27) sont rectangulaires.

4. Dispositif selon l'une quelconque des revendications précédentes caractérisé en ce que la bride spécifique (29) et la bride d'assemblage (21) sont percées, toutes deux, d'ouvertures rectangulaires.

5. Dispositif selon l'une quelconque des revendications précédentes, caractérisé en ce que le système de charnière mobile (13) est orienté d'un angle situé entre 20° et 45° par rapport à la direction du ressort de rappel (18).

6. Dispositif selon l'une quelconque des revendications précédentes caractérisé en ce que les deux butées arrières (23, 19) sont en forme de queue d'aronde.

7. Dispositif selon l'une quelconque des revendications précédentes, caractérisé en ce que l'extrémité libre (36) du ressort de rappel (18) a la forme d'un "U" évasé.

8. Dispositif selon l'une quelconque des revendications précédentes caractérisé en ce que l'amortisseur (31) est une couche de mousse alvéolaire.

9. Dispositif selon l'une quelconque des revendications précédentes, caractérisé en ce que le ressort de rappel (18) est une lamelle en bronze beryllium.

## Ansprüche

1. Vorrichtung zur elektrischen und mechanischen Kopplung eines Gehäuses eines Mikrowellenkopfes mit einer Hülle (12) einer Mikrowellenquelle auf einem Träger (10), wobei der Träger (10) auf einer seiner Seiten ein bewegliches Scharniersystem (13) besitzt, das von einem Zugglied (14), einem Befestigungsteil (15) und einem Betätigungshebel (16) gebildet wird, wobei der Träger außerdem eine Rückholfeder (18) in Lamellenform aufweist, die auf dem Träger befestigt ist, und die Feder mit einem ihrer Enden festgehalten und so angeordnet ist, daß das Zugglied (14) des beweglichen Scharniersystems auf dem freien Ende (36) dieser Feder (18) aufliegen kann, wobei der Träger außerdem einen rückwärtigen Anschlag (19) und Positionierstifte (32) zur Positionierung der Hülle der Quelle besitzt, während die Hülle der Quelle (12) einen biegsamen metallischen Wellenleiter (25) sowie auf einer ihrer Seiten einen spezifischen Flansch (29) besitzt, der am Ende des biegsamen Wellenleiters sitzt und eine Öffnung sowie zwei auch die elektrische Kopplung sichernde Zentrierstifte (30) aufweist, wobei ein Dämpfungsglied (31) zwischen dem Flansch (29) und dem Körper der Hülle der Quelle sitzt und das Gehäuse des Mikrowellenkopfs (11) auf einer ersten Seite einen Montageflansch (21) mit einer Öffnung und zwei Löchern (30') besitzt, die mit den Zentrierstiften zusammenwirken sollen, während auf einer zweiten Seite ein Haken (22) angeordnet ist, der das Zugglied ergreifen kann, und ein weiterer rückwärtiger Anschlag (23), der am rückwärtigen Anschlag des Trägers verriegelt wird, wenn das Gehäuse an die Hülle gekoppelt ist.

2. Vorrichtung nach Anspruch 1, dadurch gekennzeichnet, daß der biegsame Wellenleiter (25) in der Verlängerung von starren Wellenleitern (26, 27) angeordnet ist.

3. Vorrichtung nach Anspruch 2, dadurch gekennzeichnet, daß diese Wellenleiter (25, 26, 27) Rechteckquerschnitt besitzen.

4. Vorrichtung nach einem beliebigen der vorhergehenden Ansprüche, dadurch gekennzeichnet, daß der spezifische Flansch (29) und der Montageflansch (21) je eine rechteckige Öffnung besitzen.

5. Vorrichtung nach einem beliebigen der vorhergehenden Ansprüche, dadurch gekennzeichnet, daß das bewegliche Scharniersystem (13) bezüglich der Richtung der Rückholfeder (18) in einen Winkel zwischen 20° und 45° ausgerichtet ist.

6. Vorrichtung nach einem beliebigen der vorhergehenden Ansprüche, dadurch gekennzeichnet, daß die beiden rückwärtigen Anschläge (23, 19) schwalbenschwanzförmig ausgebildet sind.

7. Vorrichtung nach einem beliebigen der vorhergehenden Ansprüche, dadurch gekennzeichnet, daß das freie Ende (36) der Rückholfeder (18) die Form eines aufgebogenen U besitzt.

8. Vorrichtung nach einem beliebigen der vorhergehenden Ansprüche, dadurch gekennzeichnet, daß das Dämpfungsglied (31) eine Schicht aus Schaum mit Hohlräumen ist.

9. Vorrichtung nach einem beliebigen der vorhergehenden Ansprüche, dadurch gekennzeichnet, daß die Rückholfeder (18) eine Lamelle aus Berylliumbronze ist.

## Claims

1. A device for electrically and mechanically coupling a microwave head case to an envelope (12) of a microwave source on a support (10), wherein the support (10) includes a toggle fastener system (13) on one of its faces, said toggle fastener system including a draw-bar (14), a fixing portion (15), and an operating lever (16), the support further including a blade-shaped return spring (18) having one end fixed to the support and situated so as to enable the draw-bar (14) of the toggle fastener system to rest on the free end (36) of this spring (18), wherein the support further includes a back stop (19) and position pegs (32) for positioning the source envelope (12), the latter comprising a flexible metal waveguide (25) and a special flange (29) disposed on one end face of the flexible waveguide and having an opening therethrough, two centering pegs (30) disposed on the special flange, and additionally ensuring the electric coupling, a damper (31) disposed between this special flange (29) and the body of the source envelope, and wherein the microwave head case (11) includes an assembly flange (21) on a first face thereof, said assembly flange including an opening and two orifices (30') intended to cooperate with said centering pegs, and on a second face of the case (11), a hook (22) allowing to catch the draw-bar, and an additional back stop (23) suitable for being locked at the backstop of the support when the case is coupled to the envelope.

2. A device according to claim 1, characterized in that the flexible waveguide (25) lies in the extension of rigid waveguides (26, 27).

3. A device according to claim 2, characterized in that the waveguides (25, 26, 27) are rectangular waveguides.

4. A device according to any one of the preceding claims, characterized in that the special flange (29) and the assembly flange (21) are both provided with rectangular openings.

5. A device according to any one of the preceding claims, characterized in that the toggle fastener system (13) is oriented at an angle lying in the range 20° to 45° relative to the direction of the return spring (18).

6. A device according to any one of the preceding claims, characterized in that the two back stops (23, 19) are dovetailed in shape.

7. A device according to any one of the preceding claims, characterized in that the free end (36) of the return spring (18) has a flared U-shape.

8. A device according to any one of the preceding claims, characterized in that the damper (31) is a layer of cellular foam.

9. A device according to any one of the preceding claims, characterized in that the return spring (18) is a blade of beryllium bronze.

# FIG.1

EP 0 239 912 B1

# FIG.2

# FIG.3

# FIG.4

# FIG.5

# FIG.6

# FIG.7

# FIG.8

# FIG.9